Europäisches Patentamt

European Patent Office

Office européen des brevets

(11) Numéro de publication: **0 424 222 A1**

# DEMANDE DE BREVET EUROPEEN

(21) Numéro de dépôt: **90402855.2**

(22) Date de dépôt: **12.10.90**

(51) Int. Cl.⁵: **H03K 19/0952**, H01L 27/02

(30) Priorité: **17.10.89 FR 8913536**

(43) Date de publication de la demande:
**24.04.91 Bulletin 91/17**

(84) Etats contractants désignés:
**DE GB NL**

(71) Demandeur: **THOMSON COMPOSANTS MICROONDES**
**51, Esplanade du Général de Gaulle**
**F-92800 Puteaux(FR)**

(72) Inventeur: **Gobbi, José Maria**
**THOMSON-CSF SCPI Cédex 67**
**F-92045 Paris la Défense(FR)**
Inventeur: **Le Berre, Louis**
**THOMSON-CSF SCPI Cédex 67**
**F-92045 Paris la Défense(FR)**

(74) Mandataire: **Taboureau, James et al**
**THOMSON-CSF SCPI**
**F-92045 Paris La Défense Cédex 67(FR)**

(54) **Circuit intégré logique, à temps de basculement réglable.**

㉗ L'invention concerne un circuit intégré logique dont le temps de basculement entre deux états logiques 0 et 1 est réglable.

Dans une porte logique telle qu'un inverseur (7 + 8), le temps de basculement, sur la sortie (S), est fonction du courant débité par le transistor de charge (8) ou par le transistor de signal (7). Ce temps est réglable, soit en temps de montée, soit en temps de descente , en remplaçant au moins un transistor monodrain par un transistor multidrains (7), dont le débit est fixé par le nombre de drains connectés.

Application aux circuits prédiffusés (Si) ou préimplantés (GaAs).

FIG.6

## CIRCUIT INTEGRE LOGIQUE, A TEMPS DE BASCULEMENT REGLABLE.

La présente invention concerne un circuit intégré logique, prédiffusé ou préimplanté, dont les vitesses de passages entre deux états logiques, 0 et 1, sont réglables par un choix de composants effectué au moment de la métallisation qui personnalise ce circuit prédiffusé ou préimplanté.

Les circuits personnalisables sont des circuits qui comportent une pluralité de composants discrets -diodes, transistors- ou de fonctions élémentaires- portes logiques, inverseurs... etc- qui ne sont pas interconnnectés : le réseau d'interconnexions métalliques est déposé lorsque l'utilisateur a fourni son schéma électrique, ce qui personnifie ce circuit d'usage général. Le plus fréquemment, une fraction seulement des composants disponibles est utilisée pour former le circuit d'utilisation.

Ce type de circuits personnalisables est dénommé CIC, c'est à dire "circuit intégré client" ou "custom integrated circuit", ou encore, de façon générique, "prédiffusé", bien qu'il soit plus exact de dire "préimplanté" si le circuit est réalisé sur GaAs ou matériaux du groupe III-V. L'invention concerne les circuits prédiffusés sur Si ou préimplantés sur GaAs.

Les composants et fonctions préimplantés ont des caractéristiques, telles que leur vitesse, ou fréquence de coupure, qui sont fixées par la technologie utilisée : les interconnexions qui sont déposées ultérieurement ne peuvent pas changer ces caractéristiques, elles ne peuvent que regrouper des composants existant, ou négliger des composants inutilisés. En conséquence, les circuits réalisés ont des performances égales à celles des composants discrets et des fonctions élémentaires qui les composent, et ces performances sont figées par la technologie utilisée.

L'invention permet de réaliser des circuits intégrés logiques, prédiffusés ou préimplantés, dont les caractéristiques de vitesses de basculement entra deux états logiques, de 0 logique à 1 logique ou réciproquement, sont réglables. Ce résultat est obtenu au moyen de transistors multidrains, qui sont équivalents à une pluralité de transistors montés en parallèle, alimentés et commandés simultanément. Puisqu'il s'agit de circuits, prédiffusés ou préimplantés, le nombre et la position des transistors qui sont utilisés au moment de la métallisation finale du circuit personnalisable permet de modifier soit la vitesse de basculement de 0 logique à 1 logique (front de montée), soit la vitesse de basculement de 1 logique à 0 logique (front de descente), soit les deux simultanément. En effet, on peut considérer que, pour un étage logique donné, la suite du circuit logique est équivalente à une capacité, à charger ou à décharger. La vitesse de charge ou décharge de cette capacité peut être modifiée en disposant en parallèle un nombre variable de transistors, qui fournissent ou absorbent un courant proportionnel au nombre de transistors montés en parallèle (en supposant qu'ils sont tous de mêmes dimensions).

De façon plus précise, l'invention concerne un circuit intégré logique, comportant au moins une porte logique, dont la sortie délivre un signal logique, 0 ou 1, complémentaire du signal logique personnalisable, 1 ou 0, appliqué sur son entrée, ce circuit intégré étant caractérisé en ce qu'il comporte au moins un transistor multidrains, dans la dite porte logique, le nombre de drains connectés sur la sortie de la porte permettant de régler le temps de basculement d'un premier état logique à un second état logique.

L'invention sera mieux comprise au moyen des explications plus détaillées qui suivent maintenant, qui s'appuient sur les figures jointes en annexe qui représentent :
- figure 1 et 2 : schémas de charge et de décharge, respectivement, d'un circuit monté en sortie d'un inverseur, selon l'art connu,
- figures 3 et 4 : schémas de charge et de décharge, respectivement, d'un circuit monté en sortie d'un inverseur, selon l'invention.
- figure 5 : schéma d'équivalence d'une porte multridrain, selon l'invention,
- figure 6 : schéma d'un circuit logique comportant deux transistors multidrains, selon l'invention,
- figure 7 : schéma électrique d'une bascule D, selon l'art connu,
- figure 8 : schéma électrique d'une bascule D, en portes multidrain, selon l'invention,
- figure 9 : exemple d'implantation d'une bascule D en portes multidrain selon l'invention.

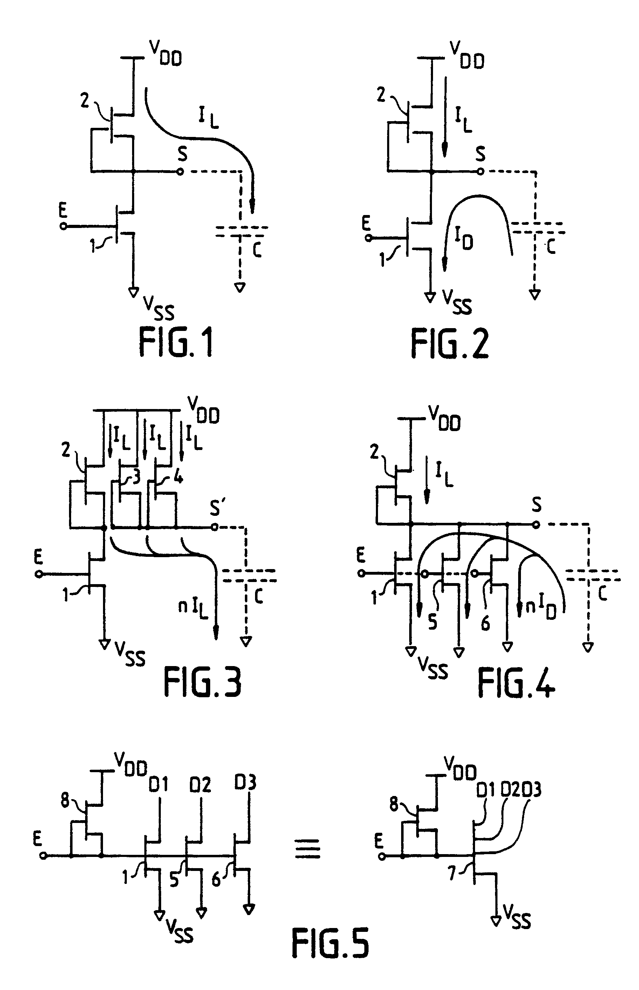

Considérons un circuit inverseur élémentaire tel que celui représenté en figure 1 : ce type de circuit est à la base des circuits logiques. Il est constitué d'un transistor 1, dont la grille constitue l'entrée de l'inverseur, et qui est chargé par un transistor 2 : les deux transistors sont montés en série entre une source de courant $V_{DD}$ et une source de courant $V_{SS}$ qui est souvent la masse. Le point commun aux deux transistors constitue la sortie S, reliée à un étage suivant de circuit logique.

On peut assimiler l'étage suivant à une capacité équivalente C, représentée en pointillé. L'inverseur fonctionne d'autant plus vite qu'il est capable de charger ou de décharger plus vite la capacité équivalente C.

Le passage de l'état logique 0 à l'état logique 1 correspond à la charge de la capacité C, par un courant I$_L$ représenté sur la figure 1 par une flèche : ce courant de charge est commandé par le transistor de charge 2. Plus le transistor 2 est important, plus le courant I$_L$ est important, plus rapide est le temps de montée de O logique à 1 logique.

Réciproquement, en figure 2, le passage de l'état logique 1 à l'état logique 0 correspond à la décharge de la capacité C. La courant de décharge I$_D$ passe par le transistor de signal 1, qui tire également le courant I$_L$ que continue à fournir le transistor de charge 2. Plus le transistor 1 est important, plus vite le courant I$_D$ est déchargé; plus rapide est le temps de descente de 1 logique à 0 logique.

Selon l'invention, les temps de basculement d'un inverseur de 0 logique à 1 logique et réciproquement peuvent être modifiés et accélérés en disposant en parallèle une pluralité de transistors, ainsi que représentés en figures 3 et 4.

De la même façon, en figure 4, le temps de descente de 1 à 0 est amélioré au moyen d'une pluralité de transistors tels que 5 et 6, montés en parallèle avec le transistor de signal 1, et commandés simultanément par le signal d'entrée E.

Ainsi, il est possible, en connectant un ou plusieurs transistors en parallèle sur les deux transistors d'un inverseur, de modifier à volonté la vitesse de montée, ou la vitesse de descente, ou les deux, entre les deux positions 0 logique et 1 logique. Cette opération de réglage de caractéristiques est particulièrement aisée avec les circuits personnalisables, prédiffusés, dans lesquels il suffit d'adapter le masque de métallisation finale pour choisir le nombre de transistors montés en parallèle.

Cependant, au lieu de monter en parallèle une pluralité de transistors comportant autant de sources, de grilles et de drains, il est avantageux d'utiliser des transistors multidrains, qui sont connus.

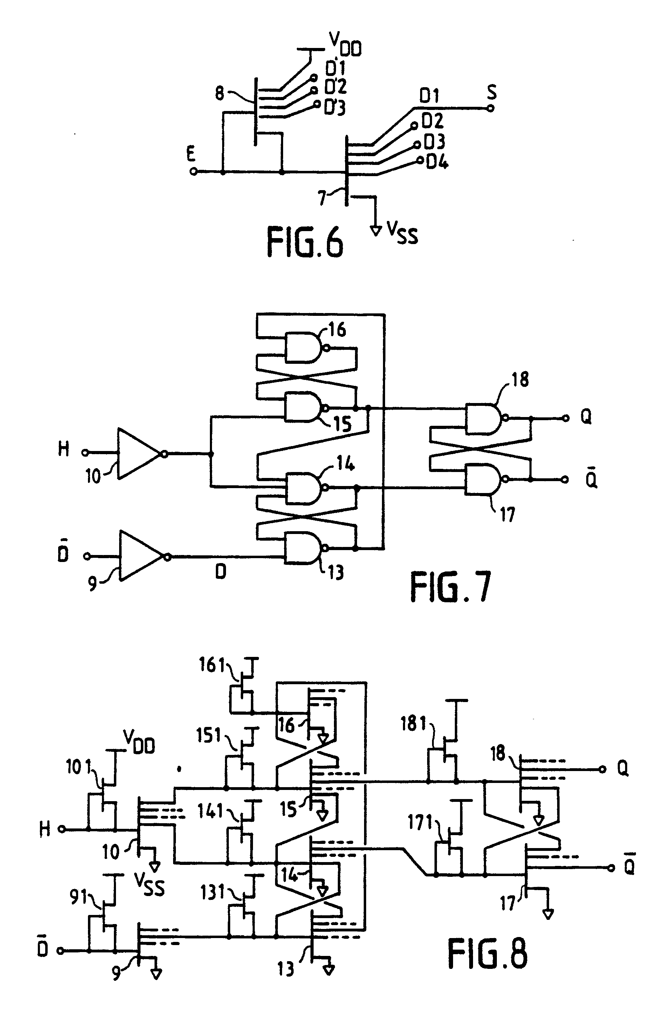

Un transistor multidrains est représenté sur la partie droite de la figure 5, et son équivalence sur la partie gauche. Le transistor multidrains 7, à enrichissement ne comporte qu'une seule source reliée à V$_{SS}$ et une seule grille qui commande plusieurs drains D$_1$, D$_2$, D$_3$... équivalents à plusieurs transistors élémentaires tels que 1,5,6... par exemple. Un transistor à appauvrissement 8, connecté entre V$_{DD}$ et la grille du transistor 7, constitue un injecteur de courant dans le transistor multidrains.

Considérons maintenant un circuit logique comportant une succession d'étages inverseurs, ou portes DCFL : la sortie du premier étage, sur le drain du transistor 1, est appliquée sur la grille du transistor d'entrée du second étage. Par conséquent, le transistor de charge 2 du premier étage peut être, par une équivalence de dessin, être connecté sur la grille du transistor d'entrée du second étage, et le transistor multidrains 7 + 8 représenté en figure 5 est bien équivalent à une porte logique inverseuse, dont le transistor de charge 8 est décalé d'un rang dans une succession de portes.

La figure 6 représente un circuit logique selon l'invention. Il est constitué d'un transistor multidrains 7 à enrichissement, alimenté sur sa grille par un autre transistor multidrains 8 à appauvrissement. En fonction de ce qui a été exposé, les vitesses de basculement d'un premier état logique à un second état logique de ce circuit selon l'invention sont réglables, au moment de la personnalisation de ce circuit prédiffusé, par la métallisation d'un nombre variable de drains. La vitesse de basculement de O logique à 1 logique est d'autant plus rapide que davantage de drains D'$_1$, D'$_2$, D'$_3$... sont reliés à V$_{DD}$. La vitesse de basculement de 1 logique à O logique est d'autant plus rapide que davantage de drains D$_1$, D$_2$, D$_3$... sont reliés à l'étage suivant.

Un exemple d'application est donné par une bascule D, dont le schéma logique simplifié, selon l'art connu, est représenté en figure 7. Les entrées de données D et d'horloge H sont appliquées sur deux inverseurs 9 et 10. Six portes ET-NON 13 à 18 traitent les signaux de façon connue, et délivrent sur les sorties les signaux complémentaires Q et Q.

Le schéma simplifié de cette bascule D, réalisée au moyen de transistors multidrains, est représenté en figure 8. Les mêmes indices de repère qu'en figure 7 sont conservés pour identifier les mêmes portes NON ou ET-NON, et les transistors injecteurs de courant reprennent l'indice du transistor multidrains correspondant, plus le suffixe "1".

Les transistors multidrains 10 et 13 à 18 sont munis de drains prolongés par un pointillé : cette convention symbolise la possibilité pour le concepteur de brancher plusieurs drains en parallèle pour régler la vitesse de basculement d'une porte. Par exemple, au moyen de métallisations adéquates sur le circuit prédiffusé, le transistor multidrains 10 pourrait avoir une pluralité de drains connectés sur le transistor 15, et une pluralité de drains connectés sur le transistor 14.

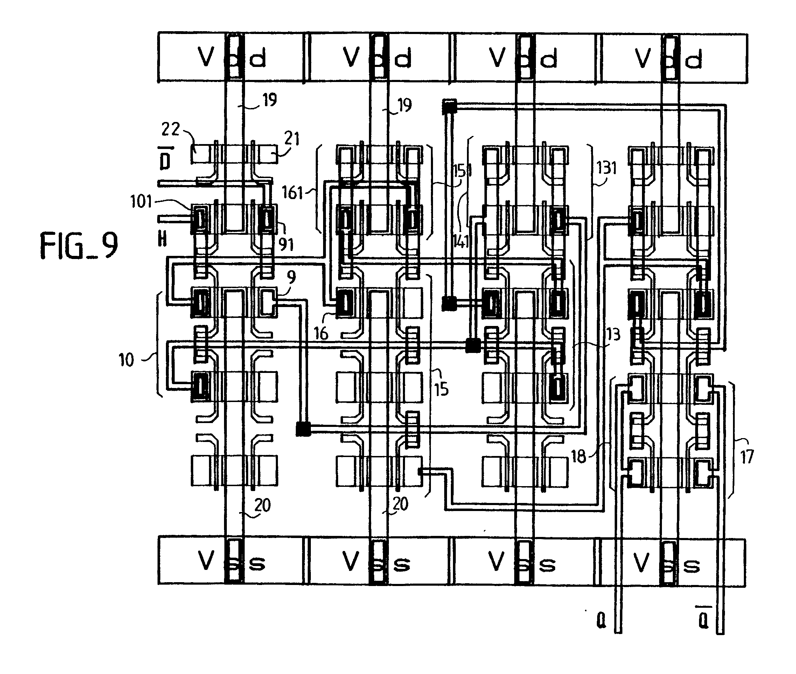

Pour diminuer la longueur des interconnexions, et profiter d'une organisation préexistante dans un circuit prédiffusé, on implante les transistors multidrains en une structure dite "totem", représentée en figure 9. Les transistors sont regroupés en colonnes et en lignes qui facilitent l'interconnexion par bandes droites de métallisations.

La connexion d'entrée d'une porte peut être plus longue que les autres connexions d'entrées d'autres portes : elle a plus de capacités parasites et, pour ne pas pénaliser cette porte, son transistor de charge doit être plus grand. En circuit intégré, même prédiffusé, il est impossible d'opérer une variation continuelle des dimensions des transistors de charge, mais il est possible de modifier leurs performances par le choix du nombre de drains qui sont métallisés au moment de la personnalisation du circuit.

Le choix des combinaisons de transistors de charge permet de moduler la vitesse du basculement de 0 logique à 1 logique, sans affecter le temps de descente de 1 logique à 0 logique en mettant en parallèle une pluralité de drains : les sorties Q et Q, en bas à droite de la figure 9, en montrent un exemple.

Sur cette figure, la métallisation qui apporte la tension d'alimentation $V_{DD}$ est en haut de la figure, et la métallisation qui apporte la tension $V_{SS}$ est en bas : en partent des ramifications 19 qui couvrent tous les drains prédiffusés des transistors de charge, et 20 qui couvrent toutes les sources des transistors de signaux. L'organisation "totem" en deux colonnes de part et d'autre des bus de polarisation 19 et 20 favorise la densité d'intégration.

Par comparaison avec la figure 8, on reconnaît que le signal d'entrée D est appliqué sur la grille du transistor 9 à un seul drain; l'injecteur de courant 91 est lui aussi simple, mais on aurait pu si nécessaire lui adjoindre le transistor 21, inutilisé. Le signal d'entrée H, avec injecteur de courant par le transistor 101 - le transistor 22 est inutilisé - est appliqué sur le transistor 10, à deux drains. Sur un premier drain, pour un transistor 15 à trois drains, on a choisi un transistor de charge 151 qui regroupe deux transistors prédiffusés de même pour le transistor 14 à deux drains. De proche en proche, on reconnaîtra que ce schéma d'implantation correspond au schéma électrique de la bascule D de la figure 8, mais avec la possibilité de faire varier les courants dans les transistors multidrains, donc les vitesses de basculement entre les états logiques 0 et 1.

L'invention a été exposée en s'appuyant sur l'exemple d'un inverseur, avec application à une bascule D, mais il est évident qu'elle concerne de façon plus générale les circuits logiques, pour lesquels l'emploi de transistors multidrains permet de moduler les vitesses de basculement entre deux états logiques, au moyen de métallisations de personnalisation des circuits prédiffusés et préimplantés.

**Revendications**

1 - Circuit intégré logique personnalisable, comportant alimenté à partir de deux sources de courant $(V_{DD}, V_{SS})$ au moins une porte logique inverseuse, ce circuit étant caractérisé en ce que, en vue de régler les vitesses de basculement de la porte logique entre deux états logiques (0,1), au moins un transistor multidrains (7,8) est monté en parallèle sur la porte logique, entre sa sortie (S) et l'une au moins des sources de courant $(V_{DD}, V_{SS})$, la vitesse de basculement étant réglée par le nombre de drains $(D_2, D_4)$ connectés sur ladite source de courant.

2 - Circuit intégré logique selon la revendication 1, caractérisé en ce que, la porte logique étant formée par un transistor de signal (7), dont la grille constitue l'entrée (E) et le drain constitue la sortie (S), et par un transistor de charge (8), un transistor multidrains (8) monté en transistor de charge diminue le temps de montée dans le basculement de l'état 0 logique à l'état 1 logique.

3 - Circuit intégré logique selon la revendication 1, caractérisé en ce que la porte logique étant formée par un transistor de signal (7), dont la grille constitue l'entrée (E) et le drain constitue la sortie (S), et par un transistor de charge (8), un transistor multidrains (7) monté en transistor de signal diminue le temps de descente dans le basculement de l'état 1 logique à l'état 0 logique.

4 - Circuit intégré logique selon la revendication 1, caractérisé en ce que, la vitesse de basculement entre deux états logiques étant fonction du courant débité par la porte logique (7+8), la vitesse de basculement est réglée par le nombre de drains connectés en parallèle dans le transistor multidrains.

5 - Circuit intégré logique selon la revendication 1, caractérisé en ce qu'il est réalisé sous forme de circuit prédiffusé (Si) ou préimplanté (GaAs), dans lequel le nombre de drains utilisés dans un transistor multidrains est déterminé par la métallisation de personnalisation du circuit prédiffusé ou préimplanté.

6 - Circuit intégré logique selon la revendication 5, caractérisé en ce que les transistors constituant le circuit prédiffusé ou préimplanté sont disposés selon une architecture dite en totem, en colonnes et en rangées, la métallisation de personnalisation étant constituée de segments rectilignes déposés entre les colonnes et les rangées de transistors.

FIG.1

FIG.2

FIG.3

FIG.4

FIG.5

FIG.6

FIG.7

FIG.8

FIG_9

**Office européen
des brevets**

**RAPPORT DE RECHERCHE
EUROPEENNE**

Numéro de la demande

**EP 90 40 2855**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | EP-A-0 186 940   (TRW INC.)<br>* Page 8, ligne 27 - page 11, ligne 23; figures 1-4 *<br>– – – | 1-6 | H 03 K 19/0952<br>H 01 L 27/02 |
| Y | PROCEEDINGS OF THE IEEE, vol. 72, no. 6, juin 1984, pages 670-689, IEEE, New York, US; E.T. LEWIS: "Optimization of device area and overall delay for CMOS VLSI designs"<br>* Figures 2,3,15-18; page 671, ligne 46 - page 675, ligne 31; page 676, ligne 36 - page 688, ligne 22 *<br>– – – | 1-6 | |
| A | PATENT ABSTRACTS OF JAPAN, vol. 8, no. 8 (E-221), 13 janvier 1984;<br>& JP-A-58 173 868 (MITSUBISHI DENKI K.K.) 12-10-1983<br>– – – | | |
| A | PATENT ABSTRACTS OF JAPAN, vol. 4, no. 59 (E-009), 2 mai 1980;<br>& JP-A-55 030 287 (NISSAN MOTOR CO., LTD) 04-03-1980<br>– – – – – | | |

**DOMAINES TECHNIQUES
RECHERCHES (Int. Cl.5)**

H 03 K
H 01 L

Le présent rapport de recherche a été établi pour toutes les revendications

| Lieu de la recherche | Date d'achèvement de la recherche | Examinateur |
|---|---|---|
| La Haye | 18 janvier 91 | SEGAERT P.A.O.M.P. |

CATEGORIE DES DOCUMENTS CITES
X : particulièrement pertinent à lui seul
Y : particulièrement pertinent en combinaison avec un autre document de la même catégorie
A : arrière-plan technologique
O : divulgation non-écrite
P : document intercalaire
T : théorie ou principe à la base de l'invention

E : document de brevet antérieur, mais publié à la date de dépôt ou après cette date
D : cité dans la demande
L : cité pour d'autres raisons
------------------------------------------------------------
& : membre de la même famille, document correspondant